# FASCICULE DE BREVET EUROPEEN

(11) **EP 3 776 643 B1**
(45) Date de publication et mention de la délivrance du brevet: **29.05.2024**
(21) Numéro de dépôt: 19721379.6
(22) Date de dépôt: 27.03.2019
(51) Int. Cl.: H01L 21/762

(54) **PROCEDE DE TRANSFERT D'UNE COUCHE**
SCHICHTTRANSFERVERFAHREN
LAYER TRANSFER METHOD

(30) Priorité: 29.03.2018 FR 1800257
(43) Date de publication de la demande: 17.02.2021
(73) Titulaire: SOITEC, 38190 Bernin (FR)
(72) Inventeur: BELHACHEMI, Djamel, 38400 Saint Martin d'Hères (FR)
(74) Mandataire: IP Trust
(86) Numéro de dépôt international: PCT/IB2019/000206
(87) Numéro de publication internationale: WO 2019/186267

(56) Documents cités:
- FR-A1- 2 940 852
- US-B2- 8 679 946
- NORIKO YAMADA ET AL: "Methylsiloxane Spin-on-Glass Films for Low Dielectric Constant Interlayer Dielectrics", JOURNAL OF THE ELECTROCHEMICAL SOCIETY, vol. 147, no. 4, 1 janvier 2000 (2000-01-01), pages 1477-1480, XP055534110, ISSN: 0013-4651, DOI: 10.1149/1.1393381

## Description

### DOMAINE DE L'INVENTION

La présente invention concerne un procédé de transfert d'une couche.

### ETAT DE LA TECHNIQUE

Il est connu des procédés de transfert de couche comprenant une étape de fourniture d'un substrat initial, une étape de fourniture d'un substrat intermédiaire, une première étape d'assemblage du substrat intermédiaire et du substrat initial, une étape d'amincissement du substrat initial après avoir été assemblé au substrat intermédiaire, une étape de fourniture d'un substrat final, une deuxième étape d'assemblage du substrat initial aminci et du substrat final, une étape de détachement du substrat intermédiaire après la deuxième étape d'assemblage. Un tel procédé est décrit par exemple dans le document WO0237556. FR2940852 décrit un procédé de transfert d'une couche mince vers un substrat final. Ce document cherche plus particulièrement à obtenir un procédé compatible avec des étapes intermédiaires pouvant impliquer des températures élevées, notamment au moment d'étapes d'épitaxie.

Néanmoins il persiste un besoin pour des applications de type intégration 3D de plaques comprenant par exemple des composants étant donné que ce type de procédé ne doit pas dépasser un certain budget thermique afin de ne pas détériorer lesdites composants, en particulier la présence de lignes métalliques dans le substrat initial et/ou dans le substrat final ne permet pas de dépasser des températures de 300°C maximum.

### EXPOSE DE L'INVENTION

La présente invention vise à pallier ces limitations dé l'état de la technique en proposant un procédé de transfert de couche qui est mis en oeuvre à des basses températures inférieure à 300°C voir moins. Par ceci il est possible de remédier aux problèmes actuellement rencontrés.

L'invention concerne un procédé de transfert de couche comprenant une étape de fourniture d'un substrat initial, une étape de fourniture d'un substrat intermédiaire, une première étape d'assemblage du substrat intermédiaire et du substrat initial, une étape d'amincissement du substrat initial après avoir été assemblé au substrat intermédiaire, une étape de fourniture d'un substrat final, une deuxième étape d'assemblage du substrat initial aminci et du substrat final, une étape de détachement du substrat intermédiaire après la deuxième étape d'assemblage dans lequel le substrat intermédiaire comprend du silicium en surface destinée à être assemblée au substrat initiale, le substrat initial ne comprend sensiblement pas de silicium en surface destinée à être assemblée au substrat intermédiaire, un dépôt d'une première couche de collage dite temporaire de type SOG comprenant méthylsiloxane en état liquide par enduction centrifuge se fait sur la surface du substrat initial ne comprenant sensiblement pas de silicium suivi d'un premier traitement thermique de densification de cette première couche de collage dite temporaire avant la première étape d'assemblage, la deuxième étape d'assemblage se fait via une deuxième couche de collage de type SOG comprenant silicate ou methylsilsesquioxane en état liquide et déposée par enduction centrifuge suivi d'un deuxième traitement thermique de densification, et dans lequel le substrat final est conçu de telle sorte qu'il se détériorerait lors d'une application d'un traitement thermique dépassant 300 °C.

Dans des modes de réalisation avantageux le substrat initial comprend des composants conçus de telle sorte qu'ils se détérioreraient lors d'une application d'un traitement thermique dépassant 300 °C.

Dans des modes de réalisation avantageux le premier et/ou le deuxième traitement thermique de densification se font à une température inférieure à 300°C, préférentiellement inférieure à 200°C, ou encore plus préférentiellement inférieure à 100°C.

Dans des modes de réalisation avantageux la première et/ou la deuxième étape d'assemblage se font par collage direct par adhésion moléculaire.

Dans des modes de réalisation avantageux le substrat initial est choisi parmi le groupe de niobate de lithium ou tantalate de lithium.

Dans des modes de réalisation avantageux le substrat initial est choisi parmi le groupe de GaAs, InP, ou Ge.

Dans des modes de réalisation avantageux le substrat intermédiaire est de silicium.

Dans des modes de réalisation avantageux le substrat final est de silicium comprenant des composants conçus de telle sorte qu'ils se détérioreraient lors d'une application d'un traitement thermique dépassant 300 °C.

Dans des modes de réalisation avantageux le substrat final est un plastique flexible.

Dans des modes de réalisation avantageux l'étape de détachement se fait par un traitement thermique à une température inférieure à 300°C, plus préférentiellement inférieure à 200°C, ou encore plus préférentiellement inférieure à 100°C.

### DESCRIPTION DES FIGURES

D'autres caractéristiques et avantages de l'invention seront mieux compris à la lecture de la description détaillée qui va suivre, en référence au dessin annexé sur lequel :

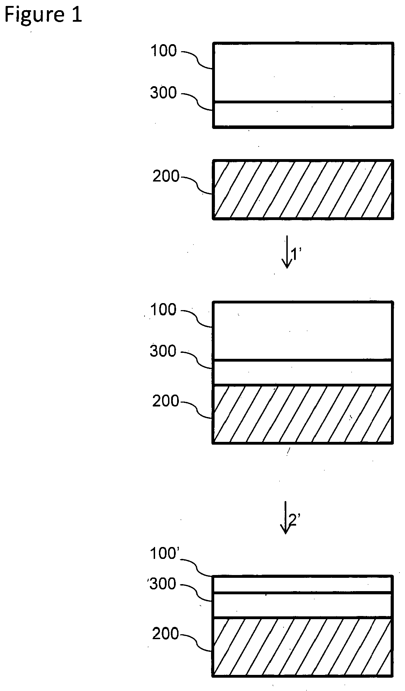

- La figure 1 illustre un procédé de transfert de couche selon un mode de réalisation de l'invention;

Pour favoriser la lisibilité des figures, les différentes couches ne sont pas nécessairement représentées à l'échelle.

### DESCRIPTION DETAILLEE DE MODES DE REALISATION DE L'INVENTION

La figure 1 illustre schématiquement le procédé de transfert d'une couche 100' obtenue d'un substrat initial 100 par une étape d'amincissement 2' après avoir été assemblé lors d'une première étape d'assemblage 1' à un substrat intermédiaire 200 via une première couche de collage dite temporaire 300. Ce procédé de transfert comprend en autre une deuxième étape d'assemblage 3' de ladite couche 100' après l'étape d'amincissement 2' à un substrat final 500 via une deuxième couche de collage 400 suivi d'une étape de détachement à l'interface présente entre le substrat initial 100 et la première couche de collage dite temporaire 300.

La première couche de collage dite temporaire 300 et la deuxième couche de collage 400 sont généralement choisi parmi la famille des SOG (du terme anglo-saxon « Spin On Glass » signifiant verre déposable par centrifugation) qui ont la propriété d'être à l'état liquide à température ambiante mais peuvent se densifier, et être rendus solides, grâce à un traitement thermique approprié.

Cette technique consiste à faire tourner le substrat sur lequel est prévu le dépôt de la couche (300, 400) sur lui-même à une vitesse sensiblement constante et relativement élevée, afin d'étaler ladite couche en état liquide de façon uniforme sur l'ensemble de la surface du substrat par force centrifuge. A cet effet, le substrat est typiquement posé et maintenu par tirage du vide sur un plateau tournant.

L'homme du métier est en mesure de déterminer les conditions opératoires, telles que le volume déposé sur la surface du substrat, la vitesse de rotation du substrat, et la durée minimale du dépôt en fonction de l'épaisseur souhaitée pour la couche adhésive.

Les épaisseurs desdites première couche de collage dite temporaire 300 et deuxième couche de collage 400 sont typiquement comprises entre 2 µm et 8 µm. En plus la technique d'enduction centrifuge utilisée est avantageuse en ce que le dépôt de la couche (300, 400) est effectué à température ambiante, et est suivi d'un recuit de densification à une température assez basse, et n'engendre donc pas de déformation du substrat sur lequel la couche diélectrique est formée.

Selon un exemple non-limitatif de l'invention le premier et/ou le deuxième traitement thermique de densification se font à une température inférieure à 300°C, préférentiellement inférieure à 200°C, ou encore plus préférentiellement inférieure à 100°C.

Etant donné que l' l'étape de détachement se fait par un traitement thermique à une température inférieure à 300°C, plus préférentiellement inférieure à 200°C, ou encore plus préférentiellement inférieure à 100°C

La première couche de collage dite temporaire 300 est choisie parmi des familles des SOG de type « méthylsiloxane », commercialisées par exemple sous les références « LSFxx » par la société FILMTRONICS.

La deuxième couche de collage 400 est choisie parmi des familles des SOG de types « silicates » ou encore « methylsilsesquioxane », commercialisées par exemple sous les références « 20B » ou « 400F » par la société FILMTRONIX ou « FOX16 » par la société DOW CORNING.

Selon l'invention le substrat initial 100 ne comprend sensiblement pas de silicium en surface destinée à être assemblée au substrat intermédiaire 200 ainsi que le substrat intermédiaire 200 comprend du silicium en surface destinée à être assemblée au substrat initial 100.

La présence ou non de silicium en surface permet ainsi d'influencer et adapter l'énergie d'interface de collage des interfaces présentes entre le substrat initial 100 et la première couche de collage dite temporaire 300 et entre la première couche de collage dite temporaire 300 et le substrat intermédiaire 200. La présence ou non de silicium et ainsi de liaisons moléculaires présentent en surface de type «silanole» détermine ces énergies d'interface de collage car ladite première couche de collage dite temporaire 300 a une composition après densification de telle sorte que des liaisons de collage se font via l'assimilations desdites liaisons moléculaires de type « silanole ».

Selon un exemple non-limitatif de l'invention, le substrat initial 100 est choisi parmi le groupe de niobate de lithium ou tantalate de lithium.

Selon un exemple non-limitatif de l'invention le substrat initial 100 est choisi parmi le groupe de GaAs, InP, ou Ge.

Selon un exemple non-limitatif de l'invention le substrat intermédiaire 200 est de silicium.

Selon un exemple non-limitatif de l'invention le substrat intermédiaire 200 est de verre.

Selon un exemple non-limitatif de l'invention le substrat intermédiaire 200 est d'un substrat quelconque autre que silicium mais recouvert en surface d'une couche de silicium polycristallin.

Le substrat initial 100 sur laquelle a été déposée et densifiée la première couche de collage dite temporaire 300 est assemblé sur le substrat intermédiaire lors de la première étape d'assemblage 1'.

Après l'étape d'amincissement 2' du substrat 100 la deuxième couche de collage 400 est déposée et densifiée soit sur le substrat final 500 soit sur la couche du substrat initial aminci 100', soit sur les deux, lors de la deuxième étape d'assemblage 3'.

La première et/ou la deuxième étape d'assemblage (1', 3') se font préférentiellement par un collage direct par adhésion moléculaire. Le collage est de préférence réalisé à température ambiante, soit environ 20°C. Il est cependant possible de réaliser le collage à chaud à une température comprise entre 20°C et 50°C, et de manière davantage préférée entre 20°C et 30°C.

De plus, l'étape de collage est avantageusement effectuée à basse pression, c'est-à-dire à une pression inférieure ou égale à 5 mTorr, ce qui permet de désorber l'eau des surfaces formant l'interface de collage, c'est-à-dire la surface de la couche électriquement isolante 300 et la surface du substrat support 100. Réaliser l'étape de collage sous vide permet d'améliorer encore davantage la désorption de l'eau à l'interface de collage.

Un traitement thermique afin de renforcer l'interface de collage peut se faire à des températures basses allant jusqu'à 300°C sans que l'ensemble de l'assemblage subit des déformations trop importantes engendrant la casse des matériaux ou encore le détachement au niveau de l'interface de collage.

La première couche de collage dite temporaire 300 selon l'invention choisie parmi des familles des SOG de type « méthylsiloxane » ensemble le fait que le substrat initial 100 ne comprend sensiblement pas de silicium en surface destinée à être assemblée au substrat intermédiaire 200 ainsi que le substrat intermédiaire 200 comprend du silicium en surface destinée à être assemblée au substrat initial 100 font en sorte que l'interface entre le substrat initial 100 et la première couche de collage dite temporaire 300 est moins forte en énergie d'interface de collage que l'interface entre la première couche de collage dite temporaire 300 et le substrat intermédiaire 200.

Ces énergies d'interface de collage obtenues par le collage direct entre la surface du substrat initial 100 au substrat intermédiaire 200 via la première couche de collage dite temporaire 300 de la présente invention sont élevées et permettent l'étape d'amincissement du substrat initial 100 par gravure mécano-chimique (CMP).

Ces énergies d'interface de collage obtenues sont tellement élevées que le procédé selon l'invention permet l'étape d'amincissement du substrat initial 100 par gravure mécano-chimique (CMP) même dans le case ou une différence importante de coéfficient thermique d'expansion entre le substrat initial 100 et le substrat intermédiaire 200 est présente ce qui est le cas pour un substrat initial 100 de lithium niobate ou lithium tantalate et une substrat intermédiaire 200 de silicium.

La deuxième étape d'assemblage se fait via une deuxième couche de collage 400 de type SOG comprenant silicate ou methylsilsesquioxane en état liquide et déposée par enduction centrifuge suivi d'un deuxième traitement thermique de densification, et dans lequel le substrat final est conçu de telle sorte qu'il se détériorerait lors d'une application d'un traitement thermique dépassant 300 °C. Il est à noter que les énergies d'interface de collage obtenues par le collage direct entre la surface du substrat initial aminci 100' au substrat final 500 via la deuxième couche de collage 400 de la présente invention sont plus élevées que les énergies d'interface de collage obtenues par le collage direct entre la surface du substrat initial 100 au substrat intermédiaire 200 via la première couche de collage dite temporaire 300 de la présente invention.

L'étape de détachement 4' se fait par un traitement thermique à une température inférieure à 300°C, plus préférentiellement inférieure à 200°C, ou encore plus préférentiellement inférieure à 100°C.

Ainsi l'étape de détachement 4' permet de détacher au niveau de l'interface entre le substrat initial 100 et la première couche de collage dite temporaire 300. Cette interface correspond à la surface initialement préparé du substrat initial 100 pour le dépôt de la première couche de collage dite temporaire 300. Le détachement libère cette surface, et ainsi les composants éventuellement présents dans le substrat initial 100, et permet ainsi une co-intégration de composants simple et prêt à être accédé facilement après avoir transfert la couche aminci du substrat initial 100'.

En autre d'une application d'une contrainte thermique telle que décrite ci-dessus, une application d'une contrainte mécanique, par exemple par insertion d'une lame en bord de plaque peut être utilisée à la place.

Selon un exemple non-limitatif de l'invention le substrat final 500 est de silicium comprenant des composants conçus de telle sorte qu'ils se détérioreraient lors d'une application d'un traitement thermique dépassant 300 °C.

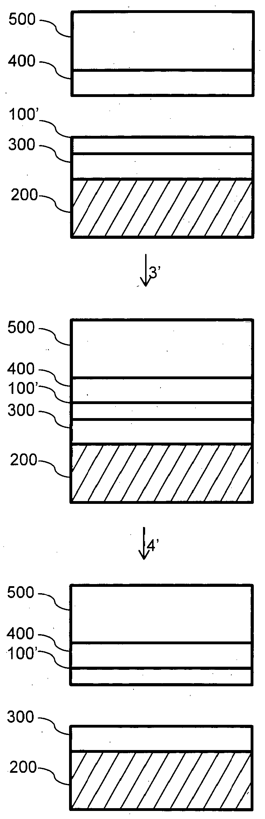

Selon un autre mode de réalisation non-limitatif, illustré schématiquement en figure 2, le substrat final 500 peut être de matériau silicium comprenant en autre une couche de piégeage vers l'interface à assembler avec la couche aminci 100' du substrat initial 100, permettant le piégeage de porteurs électriques induite par le fonctionnement en fréquence de composants radiofréquences. Cette couche permet ainsi de réduire les pertes d'insertion et améliorer les performances desdites dispositifs.

Selon un exemple non-limitatif de l'invention le substrat final 500 est d'un plastique flexible. Ensemble avec une couche amincie de substrat initial 100' en matériau piézoélectrique cela permet toute application comprenant des composants pour application « wearable ».

Par ailleurs il est à noter que la taille du substrat final 500 n'est pas limitée et un transfert multiple de différents substrat initiaux 100 sur un même substrat final est possible.

## Revendications

1. Procédé de transfert de couche comprenant les étapes suivantes :
une étape de fourniture d'un substrat initial (100) ;
une étape de fourniture d'un substrat intermédiaire (200) ;
une première étape d'assemblage (1') du substrat intermédiaire (200) et du substrat initial (100) ;
une étape d'amincissement (2') du substrat initial (100) après avoir été assemblé au substrat intermédiaire (200) ;
une étape de fourniture d'un substrat final (500) ;
une deuxième étape d'assemblage (3') du substrat initial aminci (100') et du substrat final (500) ;
une étape de détachement (4') du substrat intermédiaire (200) après la deuxième étape d'assemblage (4') ;
**caractérisé en ce que**
le substrat intermédiaire (200) comprend du silicium en surface destinée à être assemblée au substrat initial (100) ;
le substrat initial (100) ne comprend pas de silicium en surface destinée à être assemblée au substrat intermédiaire (200) ;
un dépôt d'une première couche de collage dite temporaire (300) de type SOG comprenant méthylsiloxane en état liquide par enduction centrifuge se fait sur la surface du substrat initial ne comprenant pas de silicium suivi d'un premier traitement thermique de densification de cette première couche de collage dite temporaire avant la première étape d'assemblage ;
la deuxième étape d'assemblage (3') se fait via une deuxième couche de collage (400) de type SOG comprenant silicate ou methylsilsesquioxane en état liquide et déposée par enduction centrifuge suivi d'un deuxième traitement thermique de densification ;
et **en ce que** le substrat final (500) est conçu de telle sorte qu'il se détériorerait lors d'une application d'un traitement thermique dépassant 300 °C.

2. Procédé de transfert d'une couche selon la revendication précédente dans lequel le substrat initial (100) comprend des composants conçus de telle sorte qu'ils se détérioreraient lors d'une application d'un traitement thermique dépassant 300 °C.

3. Procédé de transfert selon une des revendications précédentes dans lequel le premier et/ou le deuxième traitement thermique de densification se font à une température inférieure à 300°C, préférentiellement inférieure à 200°C.

4. Procédé de transfert selon une des revendications précédentes dans lequel la première et/ou la deuxième étape d'assemblage (1', 3') se font par collage direct par adhésion moléculaire.

5. Procédé de transfert selon une des revendications précédentes dans lequel le substrat initial (100) est choisi parmi le groupe de niobate de lithium ou tantalate de lithium.

6. Procédé de transfert selon les revendications 1 à 4 dans lequel le substrat initial (100) est choisi parmi le groupe de GaAs, InP, ou Ge.

7. Procédé de transfert selon une des revendications précédentes dans lequel le substrat intermédiaire (200) est de silicium.

8. Procédé de transfert selon une des revendications précédentes dans lequel le substrat final (500) est de silicium comprenant des composants conçus de telle sorte qu'ils se détérioreraient lors d'une application d'un traitement thermique dépassant 300 °C.

9. Procédé de transfert selon une des revendications 1 à 7 dans lequel le substrat final (500) est un plastique flexible.

10. Procédé de transfert selon une des revendications précédentes dans lequel l'étape de détachement (4') se fait par un traitement thermique à une température inférieure à 300°C, plus préférentiellement inférieure à 200°C:

## Patentansprüche

1. Verfahren zum Übertragen einer Schicht, umfassend die folgenden Schritte:
einen Schritt zum Bereitstellen eines ursprünglichen Substrats (100);
einen Schritt zum Bereitstellen eines Zwischensubstrats (200);
einen ersten Schritt zum Zusammenfügen (1') des Zwischensubstrats (200) und des ursprünglichen Substrats (100);
einen Schritt zum Ausdünnen (2') des ursprünglichen Substrats (100), nachdem es mit dem Zwischensubstrat (200) zusammengefügt wurde;
einen Schritt zum Bereitstellen eines endgültigen Substrats (500);
einen zweiten Schritt zum Zusammenfügen (3') des ausgedünnten ursprünglichen Substrats (100') und des endgültigen Substrats (500);
einen Schritt zum Ablösen (4') des Zwischensubstrats (200) nach dem zweiten Zusammenfügungsschritt (4');
**dadurch gekennzeichnet, dass:**
das Zwischensubstrat (200) Silicium auf einer Oberfläche umfasst, die dazu bestimmt ist, mit dem ursprünglichen Substrat (100) zusammengefügt zu werden;
das ursprüngliche Substrat (100) auf der Oberfläche, die dazu bestimmt ist, mit dem Zwischensubstrat (200) zusammengefügt zu werden, kein Silicium umfasst;
eine Ablagerung einer ersten, temporär genannten Klebeschicht (300) der Art SOG, umfassend Methylsiloxan in flüssigem Zustand, durch Schleuderbeschichten auf der Oberfläche des anfänglichen Substrats, umfassend kein Silicium, vorgenommen wird, gefolgt von einer ersten Wärmebehandlung zum Verdichten dieser ersten, temporär genannten Klebeschicht vor dem ersten Zusammenfügungsschritt;
der zweite Zusammenfügungsschritt (3') über eine zweite Klebeschicht (400) der Art SOG vorgenommen wird, umfassend Silicat oder Methylsilsesquioxan in flüssigem Zustand und die durch Schleuderbeschichtung abgelagert wird, gefolgt von einer zweiten Wärmebehandlung zum Verdichten;
und dass das endgültige Substrat (500) so ausgelegt ist, dass es sich bei einer Anwendung einer Wärmebehandlung, die 300 °C übersteigt, verschlechtern würde.

2. Verfahren zum Übertragen einer Schicht nach dem vorstehenden Anspruch, wobei das ursprüngliche Substrat (100) Komponenten umfasst, die so ausgelegt sind, dass sie sich bei einer Anwendung einer Wärmebehandlung, die 300 °C übersteigt, verschlechtern würden.

3. Übertragungsverfahren nach einem der vorstehenden Ansprüche, wobei die erste und/oder die zweite Wärmebehandlung zum Verdichten bei einer Temperatur von weniger als 300 °C, vorzugsweise weniger als 200 °C, vorgenommen wird.

4. Übertragungsverfahren nach einem der vorstehenden Ansprüche, wobei der erste und/oder der zweite Zusammenfügungsschritt (1', 3') durch direktes Kleben durch molekulare Adhäsion vorgenommen wird.

5. Übertragungsverfahren nach einem der vorstehenden Ansprüche, wobei das ursprüngliche Substrat (100) aus der Gruppe von Lithiumniobat oder Lithiumtantalat ausgewählt ist.

6. Übertragungsverfahren nach den Ansprüchen 1 bis 4, wobei das ursprüngliche Substrat (100) aus der Gruppe von GaAs, InP oder Ge ausgewählt ist.

7. Übertragungsverfahren nach einem der vorstehenden Ansprüche, wobei das Zwischensubstrat (200) aus Silicium ist.

8. Übertragungsverfahren nach einem der vorstehenden Ansprüche, wobei das endgültige Substrat (500) aus Silicium besteht, umfassend Komponenten, die so ausgelegt sind, dass sie sich bei einer Anwendung einer Wärmebehandlung, die 300 °C übersteigt, verschlechtern würden.

9. Übertragungsverfahren nach einem der Ansprüche 1 bis 7, wobei das endgültige Substrat (500) ein flexibler Kunststoff ist.

10. Übertragungsverfahren nach einem der vorstehenden Ansprüche, wobei der Ablöseschritt (4') durch eine Wärmebehandlung bei einer Temperatur von weniger als 300 °C, mehr bevorzugt weniger als 200 °C, vorgenommen wird.

## Claims

1. Layer transfer method comprising the following steps:
a step of providing an initial substrate (100);
a step of providing an intermediate substrate (200);
a first step (1') of connecting the intermediate substrate (200) and the initial substrate (100);
a step (2') of thinning the initial substrate (100) after it has been connected to the intermediate substrate (200);
a step of providing a final substrate (500);
a second step (3') of connecting the thinned initial substrate (100') and the final substrate (500);
a step (4') of detaching the intermediate substrate (200) after the second connecting step (4');
**characterized in that**
the intermediate substrate (200) comprises silicon on the surface intended to be connected to the initial substrate (100);
the initial substrate (100) does not comprise silicon on the surface intended to be connected to the intermediate substrate (200);
a first SOG type bonding layer (300), referred to as a temporary layer, comprising methylsiloxane in liquid state is deposited by spin coating on the surface of the initial substrate that does not comprise silicon and then a first heat treatment is carried out to densify this first bonding layer, referred to as the temporary layer, before the first connecting step;
the second connecting step (3') is carried out via a second SOG type bonding layer (400) comprising silicate or methylsilsesquioxane in liquid state and deposited by spin coating followed by a second densification heat treatment;
and **in that** the final substrate (500) is designed such that it would deteriorate during application of a heat treatment exceeding 300°C.

2. Layer transfer method according to the preceding claim, wherein the initial substrate (100) comprises components designed such that they would deteriorate during application of a heat treatment exceeding 300°C.

3. Transfer method according to either of the preceding claims, wherein the first and/or the second densification heat treatment is carried out at a temperature of less than 300°C, preferably less than 200°C.

4. Transfer method according to any of the preceding claims, wherein the first and/or the second connecting step (1', 3') is carried out by direct bonding by molecular adhesion.

5. Transfer method according to any of the preceding claims, wherein the initial substrate (100) is chosen from the group of lithium niobate or lithium tantalate.

6. Transfer method according to claims 1 to 4, wherein the initial substrate (100) is chosen from the group of GaAs, InP, or Ge.

7. Transfer method according to any of the preceding claims, wherein the intermediate substrate (200) is silicon.

8. Transfer method according to any of the preceding claims, wherein the final substrate (500) is silicon comprising components designed such that they would deteriorate during application of a heat treatment exceeding 300°C.

9. Transfer method according to any of claims 1 to 7, wherein the final substrate (500) is a flexible plastics material.

10. Transfer method according to any of the preceding claims, wherein the detachment step (4') is carried out by a heat treatment at a temperature of less than 300°C, more preferably less than 200°C.
